# EUROPÄISCHE PATENTSCHRIFT

(11) **EP 1 719 073 B1**
(45) Veröffentlichungstag und Bekanntmachung des Hinweises auf die Patenterteilung: **01.09.2010**
(21) Anmeldenummer: 05701236.1
(22) Anmeldetag: 28.01.2005
(51) Int. Cl.: G06K 19/077, B41F 17/00, G09F 3/02, H05K 3/12

(54) **VERFAHREN ZUR HERSTELLUNG VON RFID ETIKETTEN**
METHOD FOR PRODUCING RFID LABELS
PROCEDE DE PRODUCTION D'ETIQUETTES D'IDENTIFICATION PAR RADIOFREQUENCE (RFID)

(30) Priorität: 13.02.2004 DE 102004007458
(43) Veröffentlichungstag der Anmeldung: 08.11.2006
(73) Patentinhaber: manroland AG, 63075 Offenbach/Main (DE)
(72) Erfinder: WALTHER, Thomas, 63067 Offenbach (DE); Prof. Dr. Reinhard BAUMANN, 82152 Krailling (DE); Peer DILLING, 86316 Friedberg (DE); Robert WEISS, 86368 Gersthofen (DE)
(74) Vertreter: Stahl, Dietmar
(86) Internationale Anmeldenummer: PCT/EP2005/000850
(87) Internationale Veröffentlichungsnummer: WO 2005/078648

(56) Entgegenhaltungen:
- WO-A-96/40443
- WO-A-2004/006635
- WO-A-2005/013189
- US-A- 6 147 662

## Beschreibung

Die Erfindung betrifft ein Verfahren zur Herstellung von RFID Etiketten gemäß dem Oberbegriff von Anspruch 1.

### [Stand der Technik]

Die Erfindung beschreibt verschiedene Verfahren zur Herstellung von RFID (Radio Frequency Identification) Etiketten, auch Smart Labels genannt. Basis der intelligenten Etiketten (RFID, Smart Labels) ist die sogenannte Transponder Technologie. Ihr großer Vorteil liegt in der Funkverbindung zwischen dem Etikett und einem Lesegerät. Das kann den maschinellen Datenerfassungsvorgang extrem beschleunigen, weil die Lesegeräte keine optische Verbindung zu den Etiketten mehr brauchen. Damit kann z.B. der Inhalt einer Schachtel oder einer ganzen Palette fehlerfrei erfasst werden. Auch können in den intelligenten Etiketten Sicherheitscodes hinterlegt werden, wodurch Packungsfälschungen (z.B. Pharmaindustrie) oder Diebstähle eindeutig identifiziert werden können.

Ein System zur drahtlosen Identifikation besteht aus zwei Komponenten: Den RFID Etiketten (Smart Labels), die an den Waren angebracht werden und dem Schreib- / Lesegerät mit dem Daten aus dem Etikett ausgelesen oder übertragen werden können. Die Transponder speichern je nach Ausführung einfache Identifikationsnummer bis zu komplexen Daten (z.B. Verfallsdatum, Herstellungsort und -tag, Verkaufspreise etc.). Auch können Meßdaten gespeichert werden. Die Transponder bestehen meist aus einer integrierten Schaltung, einer Antenne und weiteren passiven Komponenten. In der Art der Energieversorgung wird zwischen aktive und passive Transponder unterschieden. Besitzt das Etikett eine Energieversorgung, z.B. in Form einer Batterie, so spricht man von einem aktiven System. Als passive wird ein Transponder bezeichnet, wenn er über ein externes, magnetisches oder elektrisches, Feld mit Energie versorgt wird.

Der Transponder IC, der mit der Antenne des mobilen Datenträgers verbunden ist, übernimmt das Senden / Empfangen der Daten. Bei passiven RFID Transpondern ist in der Regel die gesamte Intelligenz und Funktionalität in diesem Schaltkreis integriert.
Einige Typen enthalten darüber hinaus einen On- Chip Resonanz Kondensator für den Schwingkreis, so dass außer einer Antennenspule keine weiteren externen Komponenten erforderlich sind. Der oder die benötigten Kondensatoren können auch durch drucktechnische Verfahren erzeugt werden. Klassische und bekannte Verfahren für die Herstellung der RFID Etiketten sind die Lamination einer beschichten Folie auf das Etikett, das Drucken der Antenne mittels Siebdruckverfahren oder die Herstellung mittels Tintenstrahlverfahren.

Warensicherungsetiketten, wie die beschriebenen RFID-Etiketten werden direkt an Waren, an deren Verpackung oder an der Umverpackung für den Warentransport angebracht. Sie befanden sich also in aller Regel an der Außenseite einer Verpackung und können durch mechanische Belastung geschädigt werden. Die Beschädigung soll weitestgehend vermieden werden. Dieser Vorgang soll sich auf die Produktion und auch auf die spätere Transporttätigkeit der Ware beziehen.

Die US 6,147,662 A zeigt eine Beschreibung von Radiofrequenz-Identifizierungstags und Etiketten. Hier wird die Herstellung von Kombinationen aus Antennen oder Schaltkreisen und Chips auf Bahnware gezeigt. Die Chips werden auf den Bedruckstoff aufgesetzt und durch Greifen mit Kontakten den Bedruckstoff zur Erreichung der Schaltkreise.

In der WO 96/40443 A1 wird eine Druckmaschine zum Drucken von elektrischen Schaltkreisen gezeigt, die direkt auf ein Substrat arbeitet und eine elektrisch leitende Flüssigkeit benutzt. Weiterhin wird das Verfahren zum Betreiben einer solchen Druckmaschine beschrieben. Die Herstellung der Schaltkreise erfolgt in der Art eines Tiefdruckverfahrens.

In der WO 2004/006635 A1 wird ein Verfahren und eine Vorrichtung zum Drucken mit elektrisch leitenden Druckfarbe gezeigt. Das Druckverfahren ist als Relief- oder Hochdruckverfahren beschrieben.

Aus der WO 2005/013189 A2 ist ein Verfahren zur Herstellung von RFID-Etiketten bekannt. Hierin wird die Herstellung von Schwingkreisen oder Antennen im Bogenoffsetdruck oder im Hochdruckverfahren beschrieben. Hierbei sollen möglichst alle Teile mittels der Druckverfahren angebracht werden.

Aus der WO 99/65002 A1 ist ein RFID-Etikett bekannt, bei dem die Antenne in einem anderen Element integriert ist. Hierin wird die Anbringung von Schwingkreisen oder Antennen an einem Verkaufsartikel oder einer Verpackung beschrieben. Der RFID-Chip wird dabei in einer Vertiefung angebracht und mit einer Gegenlage aus Verpackungsmaterial oder einer Vergussmasse abgedeckt.

Aufgabe der vorliegenden Erfindung ist es, die benötigten Teile in einfacher Weise auf das Etikett zu bringen und vorzugsweise den Chip und ggf. auch die Antenne auch gegen mechanische Beschädigungen zu schützen.

Gelöst wird diese Aufgabe durch die Merkmale von Anspruch 1.
Weiterbildungen der Erfindung ergeben sich aus den jeweiligen Unteransprüchen.

### [Beispiele]

Erfindungsgemäß ist vorgesehen, dass zumindestens Teile der für die Funktion benötigten Antenne und/oder des Schwingkreises im Offsetdruck auf dem Bedruckstoff appliziert werden bzw. dass zumindest ein Teil der für die Funktion benötigten Antenne und des Schwingkreises direkt oder indirekt mit einer Hochdruckplatte appliziert wird. Nach dem Druck muss dann nur noch der Chip, der meist ungehaust ist, durch ein Klebe- oder Lötverfahren aufgebracht werden. Daher ist es als besonders vorteilhaft anzusehen, wenn der Bereich in dem der Chip angebracht werden soll, nach dem Druck und vor der Applikation des Chips durch einen verformenden Vorgang abgesenkt wird. Damit kann Absenkung des Chips und auch eine Führungsfunktion beim Applizieren erreicht werden. Es kann auch nachträglich der gesamte Bereich des Etiketts abgesenkt werden.

Beim Design der Antenne sind folgende Größen von Interesse: Die Induktivität, die Spulenfläche, der ohmsche Widerstand und die Koppelkapazität zwischen den Windungen. Abweichungen von den Kennwerten können dazu führen, dass der Kontakt zwischen dem Lese- / Schreibgerät und dem Transponder nicht zustande kommt. Die Resonanzfrequenz muss mit einer hohen Güte erreicht werden, so dass höchste Ansprüche an die Druckqualität gestellt werden.

Nach der Erfindung wird eine Metallfarbe oder leitfähige Paste über eine wasserlos Offsetplatte oder eine Nassoffsetplatte über das Gummituch auf den Bedruckstoff innerhalb einer Bogen- oder Rollenoffsetdruckmaschine übertragen wird. Die gedruckten Linien bilden die Antenne und gegebenenfalls dem gesamten Schwingkreis, der Chip wird später erforderlichenfalls aufgelötet oder aufgeklebt. Der Bedruckstoff, auf den die Bestandteile des Schwingkreises aufgedruckt werden, kann ein Faserstoff (Papier, Vlies u.a.), ein Gewebe aus Natur- oder Kunstfasern oder eine Kunststofffolie sein.

Ein wegschlagender Bedruckstoff, z.B. wenn es sich bei diesem um ein Papier oder einen anderen Faserstoff handelt, kann vorbehandelt sein, um ein Wegschlagen der leitfähigen Druckfarbe oder Paste zu vermeiden. Die Vorbehandlung kann ein Lackauftrag oder eine Auftrag einer Vordruckfarbe über ein Flexodruckwerk oder ein Offsetdruckwerk sein. Möglich ist auch, dass auf den Etikettenrücken eine Folie kaschiert ist oder das Etikett auf den Rücken schon durch den Hersteller vorbehandelt ist. Bei einem sehr starken Wegschlagen der Druckfarbe in den Bedruckstoff kann es zu einer Veränderung der Induktivität durch die dritte Ebene kommen. Der Auftrag mittels Druckplatte für den Wasserlosen Druck wird gegenüber dem Nassoffset bevorzugt, da das im Nassoffset benötigte Feuchtmittel zu einem Korrodieren der Farbe führen kann und auch die Präzision des Druckes höher ist. Auch können im wasserlosen Offset höhere Auflösungen bzw. feinere Linienstärken gedruckt werden.

Ein Kondensator, der für die Herstellung eines Schwingkreises benötigt wird, kann erzeugt werden, dass zwei Linien eng nebeneinander gedruckt werden, die an den Enden der kürzeren Linie wieder miteinander verbunden sind. Alternativ kann zuerst die Grundlinie gedruckt werden, dann wird ein isolierender Stoff darüber gedruckt und in einem dritten Druckwerk dann die Gegenlinie aufgedruckt. Der Kondensator kann auch in den Chip integriert sein. Andere Schaltkreiselemente können auch gedruckt werden, z.B. Widerstände durch eine Verjüngung der Linienstärke.

Theoretisch könnte die Kondensatorlinien auf beide Seite des Bedruckstoff gegenüberliegend aufgedruckt werden. Dazu müsste der Bedruckstoff vorher perforiert werden, dass eine Verbindung zwischen zwei gegenüberliegenden Linien beim Farbauftrag entsteht.

Abschließend kann die Antenne und der Schwingkreis mit einem Schutzlack überzogen werden, der den Aufdruck gegen mechanische, chemische oder oxidative Beschädigungen schützt. Alternativ dazu kann eine Schutzfolie aufgezogen werden.

In einem zweiten Verfahren wird ein Klebstoff über ein Druckwerk vorgedruckt, der mit dem Klebstoff bedruckte Bogen mit einer Transferfolie in Kontakt gebracht, die mit einem metallischen oder anderen leitfähigen Stoff beschichtet ist. An den Stellen mit dem aufgebrachten Klebstoff löst sich der leitfähige Stoff von der Trägerfolie und wird auf den Bedruckstoff übertragen. Dieser bildet dann den Schwingkreis, die Antenne oder Bestandteile davon.

Als drittes Verfahren kommt ein Auftrag der Linien der Antenne / des Schwingkreises mittels des Flexodruckverfahrens in Betracht. Nachteilig ist jedoch, dass Flexodruckplatte bei nicht exakt justierter Beistellung zu Quetschrändern führen können. Diese Quetschränder würden zu einer Veränderung durch Kapazitätsänderung zu einer Veränderung der Charakteristik des Schwingkreises führen.

Um die Ware einerseits mittels eines RFID-Etiketts markieren zu können und andererseits das RFID-Etikett gegen Beschädigungen zu schützen wird folgendes Verfahren vorgeschlagen:
1. Die Antenne und evtl. weitere Bestandteile des Schwingkreises werden wie oben beschrieben in einem der genannten Druckverfahren aufgebracht. Dies kann im Offsetdruck, durch direkten oder indirekten Hochdruck auf einem verformbaren Bedruckstoff erfolgen.
2. Danach wird in einem Stanzwerk oder Rillwerk, das sich in bevorzugter Ausführungsform innerhalb der Druckmaschine befindet, eine Vertiefung bzw. eine Rillung oder eine Prägung in den Bedruckstoff eingebracht. Die entsprechende Vertiefung soll später einen stabförmigen oder rechteckförmigen bzw. quadratischen Chip aufnehmen.
   Die Verformung kann auch in einer separaten Stanzmaschine während des Ausstanzvorganges oder innerhalb der Faltschachtelklebemaschine vorgenommen werden.
   Die Vertiefung sollte dabei so tief sein, dass die Oberfläche des Chips bzw. des den Schwingkreis beinhaltenden Bauelementes mit der Bedruckstoffoberfläche abschließt. Möglicherweise kann auch die Chipoberfläche etwas tiefer liegen als die Bedruckstoffoberfläche.
3. Nach dem Anbringen der Vertiefung wird der Chip bzw. Schwingkreis appliziert und durch ein klebendes oder lötendes Verfahren mit der Leiterbahn bzw. der Antenne verbunden.
Die Leiterbahn der Antenne bzw. des Schwingkreises muß insofern elastisch bzw. flexibel sein, dass sie eine Verformung in der für die Herstellung der Vertiefung benötigten Größenordnung mitmacht. Hierbei wird sich die Oberfläche des Bedruckstoffes auch im Bereich der Antenne bzw. Leiterbahn biegen. Dabei darf es nicht zu Rissen in den stromführenden Bereichen kommen. Dadurch würde sich ein höherer Widerstand einstellen, der die Charakteristik der Schaltung unzulässig ändern könnte.

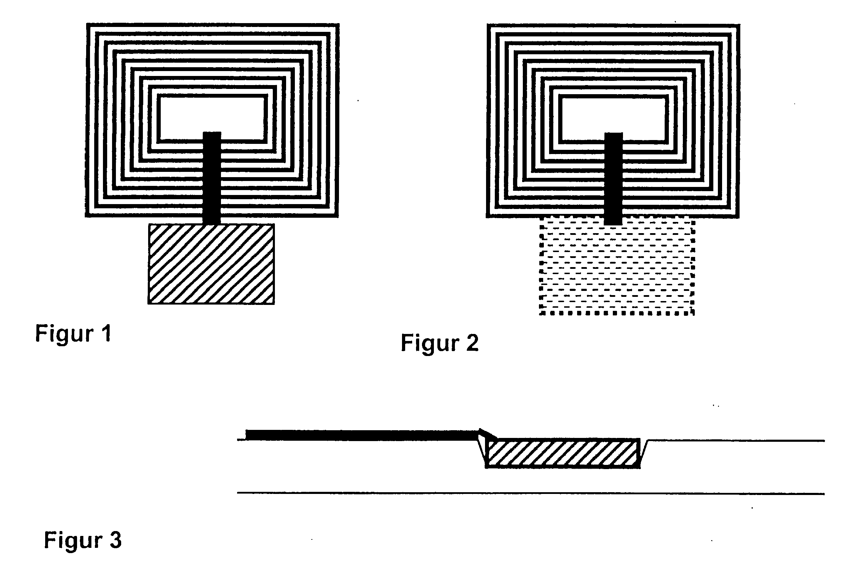

Die Anordnung des RFID-Etiketts mit Antenne und Schwingkreis ist aus den Figuren 1 bis 3 zu entnehmen.

Es ergeben sich verschiedene Vorteile dieser Verfahrensweise. Ein ungeschützter oder aber auch ein in einer Hülle eingefasster Chip wird besser vor mechanischer Beanspruchung geschützt. Verpackungen stehen in ihrer Transportverpackung oder im Lagerregal direkt Seite an Seite. Sie können daher gegeneinander scheuern. Dadurch ist die Gefahr einer mechanischen Beschädigung der Schwingkreise bzw. Chips bzw. Antennen gegeben.
Mit der vertieften Anordnung ist der Schwingkreis bzw. Chip bzw. die Antenne gegen derartige mechanische Beschädigung geschützt.
Ein weiterer Vorteil der Vertiefung ist, dass diese eine Positionierhilfe bei der Chipmontage bietet.

Alternativ könnte der gesamte Schwingkreis inkl. des Chips auf dem Bedruckstoff aufgebracht werden. In einem weiteren Arbeitsgang kann das gesamte RFID-Etikett durch einen Prägestempel so abgesenkt werden, dass das RFID-Etikett durch mechanischen Einfluß bzw. Scheuern nicht mehr beschädigt werden kann.

## Patentansprüche

1. Verfahren zur Herstellung eines RFID Etiketts unter Verwendung eines Druckverfahrens, wobei zumindest ein Teil der für die Funktion benötigten Antenne und des Schwingkreises durch Bogenoffsetdruck auf den Bedruckstoff oder mittels einer Hochdruckplatte appliziert wird und für den Druck der Leiterbahnen eine leitfähige Paste oder Druckfarbe oder eine Transferfolie, die mit einem metallischen oder anderen leitfähigen Stoff beschichtet ist und von der der leitfähige Stoff ablösbar ist, verwendet wird, dass zur Anbringung eines Schwingkreises oder von Teilen eines Schwingkreise oder eines Chips in Verbindung mit der Antenne eine wenigstens die flächige Ausdehnung des Schwingkreises oder Teiles des Schwingkreise oder Chips aufnehmende Vertiefung in den Bedruckstoff eingebracht wird und dass der Schwingkreis oder Teil des Schwingkreise oder Chip in die Vertiefung appliziert wird und dass eine leitende Verbindung zwischen dem Schwingkreis bzw. Chip und der Antenne hergestellt wird und dass als Bedruckstoff ein kompressibler Bedruckstoff verwendet wird,
**gekennzeichnet dadurch,**
- **dass** der Farbauftrag in einer Bogenoffsetdruckmaschine mit Greifertransport erfolgt und dass nach dem Druck der Bestandteile der Antenne / des Schwingkreises ein Schutzlack oder eine Schutzfarbe aufgetragen wird und
- **dass** eine Antenne bzw. ein Teil eines Schwingkreise auf den Bedruckstoff aufgebracht wird, dass der Schwingkreis oder Teil des Schwingkreise oder ein Chip auf dem Bedruckstoff in Verbindung mit der Antenne oder dem Teil des Schwingkreises appliziert wird, dass eine leitende Verbindung zwischen dem Schwingkreis bzw. Chip und der Antenne hergestellt wird, und dass mittels Verformung des Bedruckstoffes der Schwingkreis bzw. Chip und die Antenne bis wenigstens auf Höhe der Bedruckstoffoberfläche abgesenkt werden.

2. Verfahren nach Anspruch 1, **gekennzeichnet dadurch, dass** die Bestandteile der Antenne / des Schwingkreis auf die Bogenrückseite appliziert werden und der Bogen danach in einer Wendeeinrichtung umstülpt wird.

3. Verfahren nach Anspruch 1, **gekennzeichnet dadurch, dass** eine Hochdruckplatte auf einen Plattenzylinder einer Bogenoffsetdruckmaschine aufgespannt wird und der Farbübertrag indirekt über einen Gummizylinder auf den Bedruckstoff erfolgt.

4. Verfahren nach Anspruch 1, **gekennzeichnet dadurch, dass** eine Hochdruckplatte in einer Bogenoffsetdruckmaschine im direkten Kontakt mit dem Bedruckstoff steht.

5. Verfahren nach Anspruch 1, **gekennzeichnet dadurch, dass** es sich bei dem Bedruckstoff um einen Faserstoff handelt.

6. Verfahren nach Anspruch 1, **gekennzeichnet dadurch, dass** es sich bei dem Bedruckstoff um eine Folie handelt.

7. Verfahren nach Anspruch 1, **gekennzeichnet dadurch, dass** es sich beim dem Bedruckstoff um eine Gewebe aus Natur- und / oder Kunstfasern handelt.

8. Verfahren nach Anspruch 1, **gekennzeichnet dadurch, dass** bei wegschlagenden Bedruckstoffen ein Vorstrich, Vorlackierung oder ein Vordruck mit einem Lack oder einer Vordruckfarbe erfolgt, der die Wegschlageigenschaften verringert.

9. Verfahren nach Anspruch 1, **gekennzeichnet dadurch, dass** zur Herstellung eines kapazitiven Elements (Kondensator) zwei Linien streckenweise nebeneinander gedruckt werden, die an den Enden der kürzeren Linien miteinander verbunden sind.

## Claims

1. A method for producing an RFID label using a printing method, wherein at least one part of the aerial and the resonant circuit required for the function is applied to the substrate through sheet-fed offset printing or by means of a relief printing plate and for the printing of the conductor paths a conductive paste or printing ink or a transfer foil that is coated with a metal or other conductive substance and can be detached from the conductive substance is used, that for attaching a resonant circuit or parts of a resonant circuit or a chip in conjunction with the aerial a depression at least accommodating the areal expansion of the resonant circuit or part of the resonant circuit or chip is worked into the substrate and that the resonant circuit or part of the resonant circuit or chip is applied in the depression and that a conductive connection between the resonant circuit or chip and the aerial is established and that as substrate a compressible substrate is used, **characterized**
- **in that** the ink application takes place in a sheet-fed offset printing press with gripper transport and that following the printing of the parts of the aerial/the resonant circuit a protective varnish or a protective ink is applied and
- **in that** an aerial or a part of a resonant circuit is applied to the substrate, in that the resonant circuit or part of the resonant circuit or a chip is applied to the substrate in conjunction with the aerial or the part of the resonant circuit, in that a conductive connection between the resonant circuit or chip and the aerial is established and that by means of deformation of the substrate the resonant circuit or chip and the aerial are lowered to at least the level of the substrate surface.

2. The method according to Claim 1, **characterized in that** the parts of the aerial/of the resonant circuit are applied to the back of the sheet and the sheet is thereafter reversed in a reversing device.

3. The method according to Claim 1, **characterized in that** a relief printing plate is mounted on a plate cylinder of a sheet-fed offset printing press and the ink transfer on to the substrate takes place indirectly via a rubber cylinder.

4. The method according to Claim 1, **characterized in that** a relief printing plate in a sheet-fed offset printing press is in direct contact with the substrate.

5. The method according to Claim 1, **characterized in that** the substrate is a fibre material.

6. The method according to Claim 1, **characterized in that** the substrate is a foil.

7. The method according to Claim 1, **characterized in that** the substrate is a fabric of natural and/or artificial fibres.

8. The method according to Claim 1, **characterized in that** with penetrating substrates a pre-coat, pre-varnish or a pre-print with a varnish or a pre-printing ink is performed which reduces the penetration characteristics.

9. The method according to Claim 1, **characterized in that** for producing a capacitive element (capacitor) two lines are printed next to each other in parts which at the ends of the shorter lines are connected with each other.

## Revendications

1. Procédé de fabrication d'une étiquette RFID en utilisant un procédé d'impression, au moins une partie de l'antenne nécessaire au fonctionnement et du circuit oscillant étant appliquée par impression offset de feuilles sur le support d'impression ou au moyen d'une plaque à haute pression et une pâte ou une encre d'impression conductrice ou un film de transfert revêtu d'une substance métallique ou autre substance conductrice et pouvant être détaché de la substance conductrice étant utilisé pour l'impression des bandes conductrices, que, pour l'application d'un circuit oscillant ou d'éléments d'un circuit oscillant ou d'une puce en liaison avec l'antenne, un renfoncement recevant au moins l'extension surfacique du circuit oscillant ou de l'élément de circuit oscillant ou de la puce est pratiqué dans le support d'impression et que le circuit oscillant ou l'élément de circuit oscillant ou la puce est appliqué dans le renfoncement et qu'une liaison conductrice entre le circuit oscillant ou la puce et l'antenne est établie et qu'un support d'impression compressible est utilisé comme support d'impression, **caractérisé en ce que**
- l'application d'encre a lieu dans une machine d'impression offset de feuilles équipée d'un système de transport à grappin et qu'après l'impression des composantes de l'antenne /du circuit oscillant, un vernis protecteur ou une encre protectrice est appliqué et
- qu'une antenne ou un élément du circuit oscillant est appliqué sur le support d'impression, que le circuit oscillant ou l'élément de circuit oscillant ou une puce est appliqué sur le support d'impression en liaison avec l'antenne ou l'élément de circuit oscillant, qu'une liaison conductrice est établie entre le circuit oscillant ou la puce et l'antenne et que, au moyen d'une déformation du support d'impression, le circuit oscillant ou la puce et l'antenne sont descendus au moins jusqu'au niveau de la surface du support d'impression.

2. Procédé selon la revendication 1, **caractérisé en ce que** les composantes de l'antenne / du circuit oscillant sont appliquées sur le verso de la feuille et que la feuille est ensuite retournée dans un dispositif de retournement.

3. Procédé selon la revendication 1, **caractérisé en ce qu'**une plaque à haute pression est montée sur un cylindre de plaque d'une machine d'impression offset de feuilles et que le transfert d'encre a lieu indirectement via un cylindre en caoutchouc sur le support d'impression.

4. Procédé selon la revendication 1, **caractérisé en ce qu'**une plaque à haute pression est en contact direct avec le support d'impression dans une machine d'impression offset de feuilles.

5. Procédé selon la revendication 1, **caractérisé en ce que** le support d'impression est une matière fibreuse.

6. Procédé selon la revendication 1, **caractérisé en ce que** le support d'impression est un film.

7. Procédé selon la revendication 1, **caractérisé en ce que** le support d'impression est un tissu de fibres naturelles et/ou artificielles.

8. Procédé selon la revendication 1, **caractérisé en ce que,** dans le cas de supports d'impression absorbants, on réalise une pré-enduction, un pré-vernissage ou une pré-impression avec un vernis ou une encre de pré-impression qui diminue les propriétés d'absorption.

9. Procédé selon la revendication 1, **caractérisé en ce que,** pour fabriquer un élément capacitif (condensateur), on imprime sur une certaine distance deux lignes juxtaposées qui sont reliées entre elles aux extrémités des lignes les plus courtes.
